# EUROPÄISCHE PATENTSCHRIFT

(11) **EP 2 246 634 B1**
(45) Veröffentlichungstag und Bekanntmachung des Hinweises auf die Patenterteilung: **10.09.2014**
(21) Anmeldenummer: 09005824.9
(22) Anmeldetag: 27.04.2009
(51) Int. Cl.: F24F 11/02, F24F 11/00, F24F 13/04, F24F 3/044

(54) **Direkte freie Kühlung**
Direct free cooling
Refroidissement direct libre

(43) Veröffentlichungstag der Anmeldung: 03.11.2010
(73) Patentinhaber: STULZ GmbH, D-22457 Hamburg (DE)
(72) Erfinder: Seeliger, Rene, 25421 Pinneberg (DE)
(74) Vertreter: Kossak, Sabine

(56) Entgegenhaltungen:
- WO-A-89/07738
- WO-A-94/25805
- WO-A-03/073012
- DE-A1- 3 027 447
- DE-U1- 9 403 337
- US-A- 4 203 485
- US-A- 6 076 739
- US-A1- 2003 146 289
- US-A1- 2008 179 409

## Beschreibung

Die vorliegende Erfindung betrifft eine Mischbox zur Temperaturregulierung mit einem Grundkörper, durch den mindestens ein Luftstrom leitbar ist und in dem mindestens eine Filtereinrichtung angeordnet ist, durch welche der Luftstrom leitbar ist, wobei die Führung des Luftstrom durch eine Klappenanordnung mit mindestens einer Klappe erfolgt. Die Erfindung betrifft ferner eine Anlage zur Temperaturregulierung sowie ein Verfahren zum Betrieb einer solchen Anlage.

Mischboxen zur Temperaturregulierung sind aus dem Stand der Technik bekannt. Des Weiteren sind Anlagen zur Temperaturregulierung aus dem Stand der Technik für verschiedene Anwendungen bekannt. Eine Anwendungsmöglichkeit für solche Anlagen ist die Klimatisierung von einzelnen Räumen oder von vollständigen Gebäuden. Insbesondere für die Klimatisierung von Rechenzentren werden Anlagen zur Temperaturregulierung benötigt, da durch den Betrieb von Computeranlagen, beispielsweise Serveranlagen, eine erhebliche Wärmeentwicklung erfolgt. Die durch die Serveranlagen produzierte Wärme muss aus dem Raum, in dem die Serveranlagen stehen, notwendigerweise abführt werden, weil die maximale Betriebstemperaturen für solche Serveranlagen im Bereich vom 35° C liegen, welche ohne Abtransport der von den Servern produzierten Wärme innerhalb kurzer Zeit erreicht und überschritten wird.

Aus der DE 199 04 667 ist eine Anlage zur Temperaturregulierung eines Gebäudes bekannt. Die dort gezeigte Anlage umfasst ein Klimagerät, welches einen Kühlmittelkreislauf umfasst, wodurch eine indirekte Kühlung mittels des Kühlmittels des Gebäudes oder einzelner Räume ermöglicht wird. Eine solche Kühlung ist insbesondere dahingehend vorteilhaft, dass der zulässige Bereich der relativen Luftfeuchtigkeit und die gewünschte Temperatur sehr gut eingehalten werden können. Die Kühlung der gezeigten Anlage erfolgt in Abhängigkeit der Außentemperatur entweder als indirekte freie Kühlung im Winter, als aktive Kühlung im Sommer sowie als indirekte freie in Kombination mit einer aktiven Kühlung in der Übergangszeit. Durch den hohen Energiebedarf einer indirekten Kühlung ist eine solche Kühlung jedoch sehr kostenintensiv.

Aus der WO-94/25805-A ist eine Anlage gemäß dem Oberbegriff des Anspruchs 1 bekannt.

Aufgabe der vorliegenden Erfindung ist es daher eine Mischbox zur Temperaturregulierung bereitzustellen, welche eine gute Temperaturregulierung bei geringem Energieverbrauch ermöglicht. Es ist eine weitere Aufgabe der Erfindung, eine Anlage zur Temperaturregulierung sowie ein Verfahren zum Betrieb einer Anlage zur Temperaturregulierung bereitzustellen.

Erfindungsgemäß ist zur Lösung der Aufgabe bei einer Mischbox der eingangsgenannten Art vorgesehen, dass die Klappenanordnung mindestens drei Klappen umfasst, die in Abhängigkeit eines Parameters, insbesondere in Abhängigkeit eines Umgebungsparameters, steuerbar sind, und die Klappenanordnung eine Außenluftklappe und eine Umluftklappe und eine Mischluftklappe umfasst.

Durch den Einsatz von drei Klappen sind viele verschiedene Betriebszustände der Mischbox möglich, wodurch die Mischbox weitaus individueller auf verschiedene Betriebszustände und Anforderungen einstellbar ist. Somit ist es möglich den Energiebedarf zu senken, da für individuelle Betriebspunkte individuelle Einstellung vorgenommen werden können, so dass jeweils der Betriebszustand gewählt werden kann, der in diesem Betriebspunkt einen minimalen Energiebedarf hat. Ein bevorzugter Umgebungsparameter ist die Temperatur, beispielsweise die Außentemperatur. Zusätzlich oder alternativ sind auch andere Umgebungsparameter, wie die Partikelbelastung der Luft oder die Luftfeuchtigkeit als Parameter denkbar, von denen die Steuerung der Klappenanordnung abhängt.

Vorteilhafte Weiterbildungen und Ausgestaltungen der Erfindung gehen aus den Unteransprüchen hervor.

In einer vorteilhaften Ausgestaltung könnten zwei Filtereinrichtungen vorgesehen sein, durch welche der Luftstrom leitbar ist. Eine Filtereinrichtung könnte einen einzigen Filtertyp oder eine Filterkombination, beispielsweise zwei, drei oder mehr Filtertypen, umfassen, welche hintereinander von dem Luftstrom durchflossen werden. In einer bevorzugten Ausführungsform könnte eine der Filtereinrichtungen einen Filter der Filterklasse G4 und die andere Filtereinrichtung eine Kombination zweier Filter der Filterklassen G4 und F7 umfassen. Ein Luftstrom von außerhalb des Gebäudes, in dem das Rechenzentrum sich befindet, könnte dann durch die Kombination der G4- und F7-Filter treten, damit durch den G4-Filter zunächst eine grobe Reinigung und nachfolgend durch den F7-Filter feine Partikel aus dem Luftstrom gefiltert werden. Bei einem Luftstrom, der aus dem Rechenzentrum in die Mischbox trifft, reicht die Filterung von feinen Partikeln durch einen F7-Filter aus, da diese Luft bereits gereinigt wurde.

Im Rahmen einer weiteren vorteilhaften Ausgestaltung könnte die Klappenanordnung derart gestaltet und/oder in Abhängigkeit des Parameters derart steuerbar sein, dass der Luftstrom eine oder beide Filtereinrichtungen durchtritt. Falls der Luftstrom lediglich eine Filtereinrichtung durchtritt, bedeutet dies, dass entweder ein 100% Luftaustausch zwischen dem zu temperierenden Raum und dem Außenbereich erfolgt oder dass ein Umluftbetrieb erfolgt. Insbesondere in den Fällen, in denen der Luftstrom eine Filtereinrichtung durchtritt, die lediglich einen Filtertyp aufweist, ist der Druckabfall meist deutlich geringer als wenn der Luftstrom eine Filterkombination durchtreten muss. Dies führt wiederum zu einer Einsparung von Energie, da im Weiteren, beispielsweise in einem Ventilator, der Druck nicht erneut aufgebaut werden muss. Werden beide Filtereinrichtungen von Luftströmen durchtreten, handelt es sich um einen Mischbetrieb, in dem sowohl ein Luftaustausch mit der Außenluft als auch eine Umluftzirkulation innerhalb des zu kühlenden Raumes erfolgt. Die Steuerung der Klappenanordnung könnte in besonders einfacher Weise mittels eines Mikrocontrollers erfolgen.

Zur Verbesserung der Temperaturregulierung könnte dem Grundköper ein Kompressor zugeordnet sein, wodurch bei bestimmten Betriebszuständen, beispielsweise bei Temperaturen der zuströmenden Luft, auch Außenluft genannt, die oberhalb von 17°C liegen. Ab 25°C könnte eine aktive Kühlung mittels des Kompressors erfolgen, während im Bereich oberhalb von 17°C und unterhalb von 25°C lediglich ein Mischbetrieb aus aktiver und direkter Kühlung erfolgen könnte, wodurch wiederum die Energiekosten gesenkt werden könnten. Unterhalb von 17°C ist eine direkte freie Kühlung möglich, so dass der Energiebedarf deutlich gesenkt und trotzdem die Grenzwerte der Richtlinie ASHRAE TC 9.9 - 2008 eingehalten werden können. Durch die Nutzung der freien Kühlung kann eine hohe Energieeffizienz gewährleistet werden, da keine Energieverluste, beispielsweise durch zusätzliche Wärmetauscher, auftreten. Der Kompressor könnte hierbei sowohl in den Grundkörper integriert sein als auch als separates Bauteil an den Grundkörper angeordnet sein. Grundsätzlich könnte das System jedoch wasser- oder luftgekühlt sein.

Gemäß einem anderen Aspekt der vorliegenden Erfindung wird eine Anlage zur Temperaturregulierung vorgeschlagen, bei der mehrere Mischboxen vorgesehen sind, welche parallel zueinander angeordnet sind. Da bei der erfindungsgemäßen Anlage keine Hydraulikauslegung, wie Verrohrung, Pumpen oder Armaturen, erforderlich ist, ist eine sehr gute Skalierbarkeit der Anlage gegeben, so dass diese jederzeit mit einfachen Mitteln je nach Anforderung erweitert oder verringert werden kann. Außerdem sind daher die Investitionskosten im Vergleich zu bekannten Systemen mit indirekter freier Kühlung geringer.

In einer weiter vorteilhaften Ausgestaltung könnte mindestens eine Ventilatoreinrichtung vorgesehen sein. Diese Ventilatoreinrichtung könnte außerhalb des zu kühlenden Raums, beispielsweise im Freien, um den Abtransport der warmen Luft zu verbessern. Insbesondere bei Außentemperaturen oberhalb von 17°C könnte ein solcher zusätzlicher Abtransport von Wärme durch die Ventilatoreinrichtung erfolgen.

Die Erfindung betrifft weiter ein Verfahren einer derartigen Anlage zur Temperaturregulierung, bei dem die Klappenanordnung derart gesteuert wird, dass in Abhängigkeit eines Parameters, insbesondere in Abhängigkeit der Temperatur, der Luftstrom eine oder beide Filtereinrichtungen durchtritt. Zur Steuerung der Klappenanordnung könnte in vorteilhafter Weise eine entsprechende Software verwendet werden. Durch das erfindungsgemäße Verfahren kann eine hohe Energieeffizienz gewährleistet werden, da keine Energieverluste, beispielsweise durch zusätzliche Wärmetauscher, auftreten.

Nachstehend wird die Erfindung an Hand eines Ausführungsbeispiels beschrieben, das schematisch in der Zeichnung dargestellt ist Dabei ist:
**Fig. 1** eine schematische Darstellung eine erfindungsgemäße Mischbox;
**Fig**. 2 eine schematische Darstellung einer erfindungsgemäßen Anlage zur Temperaturregulierung bei einem ersten Betriebszustand;
**Fig.** 3 eine schematische Darstellung einer erfindungsgemäßen Anlage zur Temperaturregulierung bei einem zweiten Betriebszustand;
**Fig.** 4 eine schematische Darstellung einer erfindungsgemäßen Anlage zur Temperaturregulierung bei einem dritten Betriebszustand;
**Fig.** 5 eine schematische Darstellung einer erfindungsgemäßen Anlage zur Temperaturregulierung bei einem vierten Betriebszustand; und
**Fig.** 6 eine schematische Darstellung einer erfindungsgemäßen Anlage zur Temperaturregulierung bei einem fünften Betriebszustand.

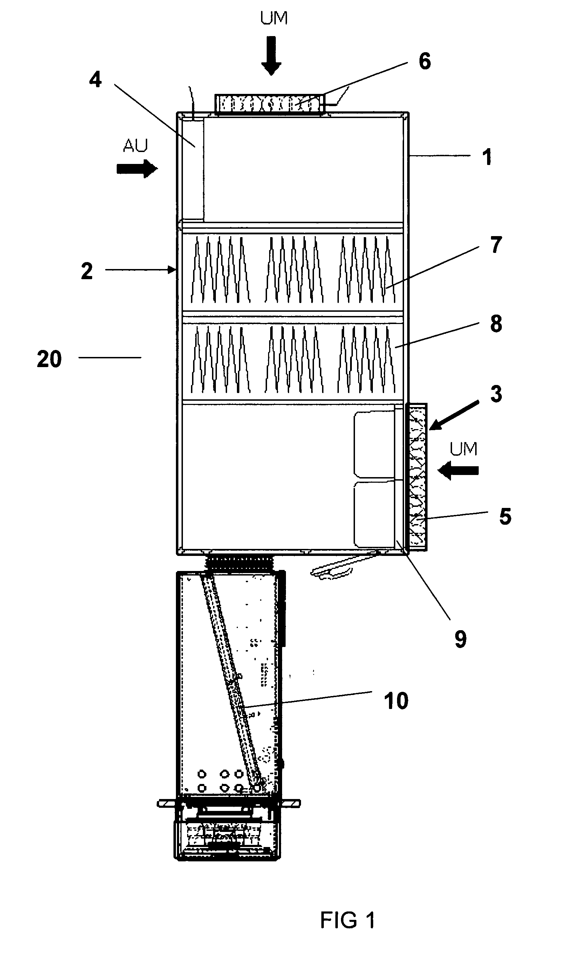

In **Fig.** 1 ist ein schematisch dargestelltes Ausführungsbeispiel einer erfindungsgemäßen Mischbox 20. Die Mischbox 20 weist einen Grundkörper 1 auf, der eine Klappenanordnung und zwei Filtereinrichtungen 2, 3 umfasst, wobei die Klappenanordnung eine Außenluftklappe 4, eine Umluftklappe 5 und eine Mischluftklappe 6 aufweist. Filtereinrichtung 2 umfasst einen G4-Filter 7, der in Strömungsrichtung der die Filtereinrichtung 2 durchtretenden Luftströme vor einem F7-Filter 8 angeordnet ist. Die Filtereinrichtung 2 wird von der Außenluft AU sowie, falls eine Filtervorwärmung erfolgt, von vorgewärmter Luft UM1 durchtreten, wenn die entsprechende Außenluftklappe 4 und gegebenenfalls die Mischluftkappe 6 geöffnet sind. Die zweite Filtereinrichtung 3 umfasst einen G4-Filter 9, welcher in den Betriebszuständen von einem Luftstrom UM2 durchtreten wird, in denen ein Umluftbetrieb erfolgt. Der Luftstrom UM2 zirkuliert in diesem Betriebszustand innerhalb des zu kühlenden Raums, der in diesem Ausführungsbeispiel ein Rechenzentrum ist. Zusätzlich ist an dem Grundköper 1 der Mischbox 20 ein separates Bauteil angebaut, in dem ein Kompressor 10 derart angeordnet ist, dass der Grundkörper 1 und das Bauteil in einer Strömungsverbindung stehen.

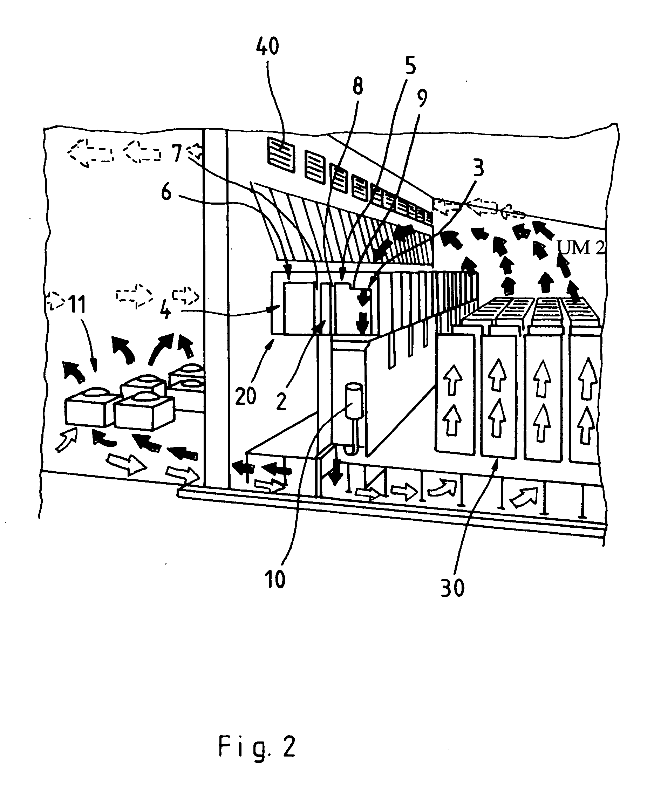

Die Arbeitsweise der Mischbox 20 innerhalb einer ebenfalls erfindungsgemäßen Anlage ist in **Fig.** 2 bis 6 gezeigt, welche fünf verschiedene Betriebszustände der Anlage zur Temperaturregulierung eines Rechenzentrums darstellen. Das Rechenzentrum weist eine Vielzahl von Servern 30 auf, welche im Betrieb Wärme produzieren. Ferner befinden sich in der Außenmauer des Rechenzentrums Lüftungsklappen 40 zum freien Luftaustausch zwischen der Raumluft des Rechenzentrums und Außenluft der Umgebung außerhalb des Gebäudes, in dem sich das Rechenzentrum befindet. Die Raumlufttemperatur innerhalb des Rechenzentrums soll in diesem Ausführungsbeispiel auf 27°C geregelt werden.

In **Fig.** 2 ist eine erfindungsgemäße Anlage zur Temperaturregulierung des Rechenzentrums in einem ersten Betriebszustand gezeigt. Dieser Betriebszustand liegt bei einer Außentemperatur vor, die gleich oder höher als 25°C ist. Bei einer derart hohen Außentemperatur wird die Anlage zur Temperaturregulierung im sogenannten Umluft- und Kompressorbetrieb betrieben. Da der Kompressor 10 in Betrieb ist, bedeutet dies, dass eine aktive Kühlung des Rechenzentrums erfolgt. Die gefüllten Pfeile symbolisieren hierbei warme Luftströme, während die ungefüllten Pfeile kühle Luftströme symbolisieren. In diesem Betriebszustand sind die Außenluftklappe 4 sowie die Mischluftklappe 6 geschlossen und ist die Umluftklappe 5 geöffnet. Es zirkuliert demnach ein Luftstrom UM2 von den Servern 30 in die Mischbox 20, durchtritt den F7-Filter 9 und wird über Ventilatoreneinrichtungen 11 an die Umgebung abgeführt. Je nach Temperaturgradient zwischen der Raumlufttemperatur im Rechenzentrum und der Außentemperatur sind auch ein durch den Temperaturgradienten bedingter geringer Luftaustausch zwischen der Raumluft und der Außenluft möglich. Diese geringen Luftströme sind durch gestrichelte Pfeile dargestellt.

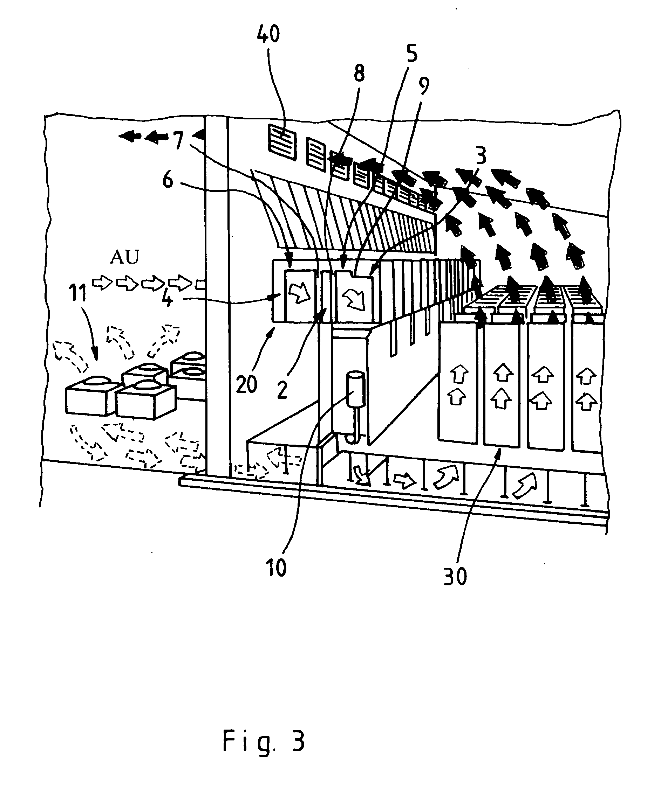

**Fig.** 3 zeigt die erfindungsgemäße Anlage zur Temperaturregulierung in einem zweiten Betriebszustand, der bei einer Außentemperatur oberhalb von 17°C und unterhalb von 25°C vorliegt. In diesem Betriebszustand erfolgt ein 100%-iger Luftaustausch innerhalb des Rechenzentrums, weshalb die Außenluftklappe 4 geöffnet ist und die Umluftklappe 5 und die Mischluftklappe 6 geschlossen sind. Der Luftstrom AU tritt demnach durch den G4-Filter 7 und den F7-Filter 8 der Filtereinrichtung 2 in die Mischbox 20 ein und tritt über die Lüftungsklappen 40 aus dem Rechenzentrum aus. Zur hinreichenden Kühlung des Rechenzentrums wird zusätzlich zur direkten Kühlung mittels des Luftaustausches der Kompressor 11 betrieben, durch den zusätzlich eine aktive Kühlung des Rechenzentrums erfolgt. Des Weiteren wird ein geringerer Strom warmer Luft durch die Ventilatoreinrichtungen 11 abgeführt.

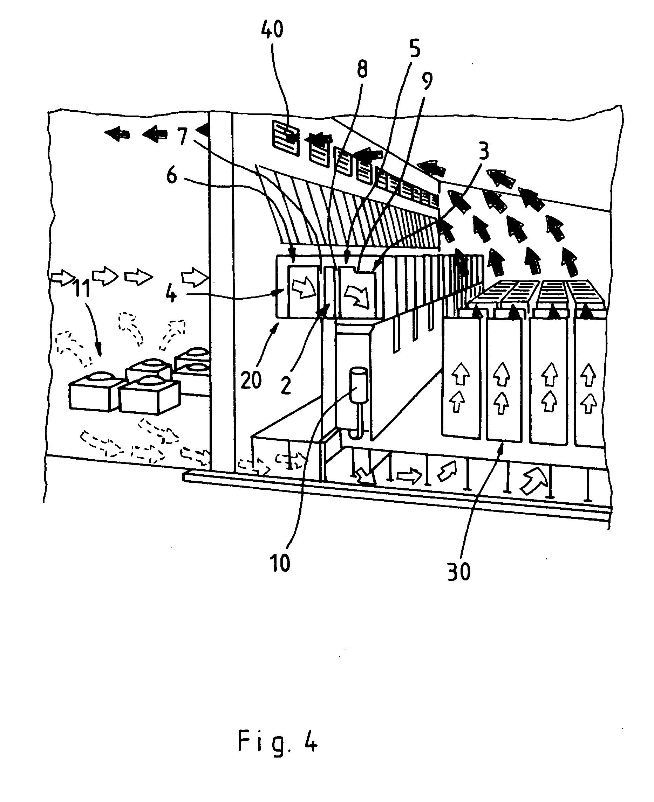

Ein dritter Betriebzustand der erfindungsgemäßen Anlage zur Temperaturregulierung ist in **Fig.** 4 dargestellt. Dieser Betriebszustand, in dem eine direkte freie Kühlung allein durch einen 100%-igen Luftaustausch erfolgt, ist bei einer Außentemperatur von 17°C möglich. Der Luftstrom AU tritt demnach durch den G4-Filter 7 und den F7-Filter 8 der Filtereinrichtung 2 in die Mischbox 20 ein und tritt über die Lüftungsklappen 40 aus dem Rechenzentrum aus. Ein Betrieb des Kompressors 10 oder der Ventilatoreneinrichtungen 11 erfolgt in diesem Betriebszustand nicht.

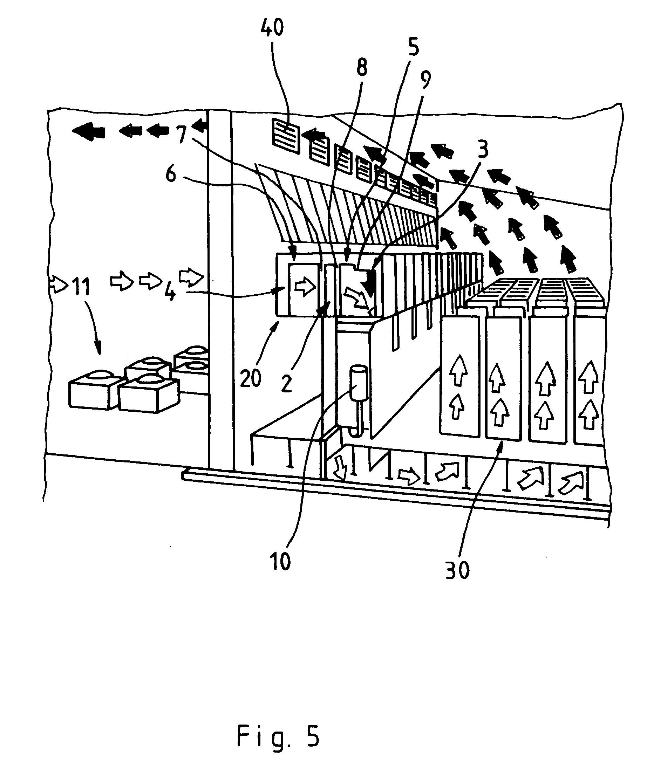

Die erfindungsgemäße Anlage zur Temperaturregulierung kann in einem vierten Betriebszustand im Mischbetrieb mit Umluft betrieben werden. Dieser Betriebszustand ist in **Fig.** 5 dargestellt. In dem hier beschriebenen Ausführungsbeispiel ist dieser Betriebszustand bei einer Außentemperatur von 0°C bis unterhalb von 17°C eingestellt. In diesem Betriebszustand, welcher in **Fig.** 5 näher gezeigt ist, sind die Außenluftklappe 4 und die Mischluftklappe 6 geöffnet, während die Umluftklappe 5 geschlossen ist.

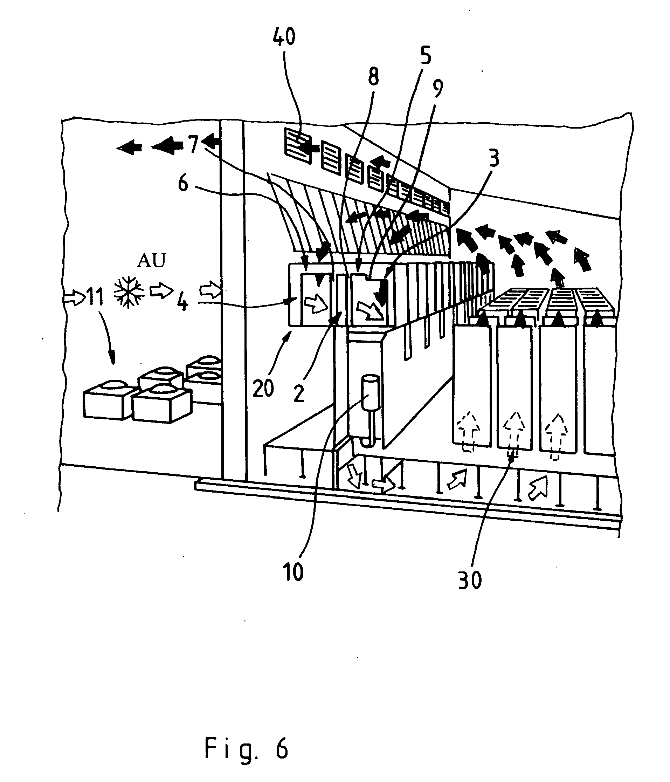

Ist die Außentemperatur niedriger als 0°C, wird die Anlage zur Temperaturregulierung in einem fünften Betriebszustand betrieben, wie in **Fig.** 6 gezeigt ist. Bei diesem Betriebszustand handelt es sich ebenfalls um einen Mischbetrieb mit Umluft und Filtervorwärmung. Hierbei wird die durch die Außenluftklappe 4 von der Umgebung in die Mischbox 20 eintretende Außenluft AU mittels der durch die Server 30 erwärmten Raumluft vorgewärmt, die durch die Mischluftklappe 6 in die Mischbox 20 eintritt. Demnach sind die Außenluftklappe 4 und die Mischluftklappe 6 bei diesem Betriebszustand geöffnet, während die Umluftklappe 5 geschlossen ist. Ferner tritt warme Luft durch die Lüftungsklappen 40 in die Umgebung aus. In den in **Fig.** 5 und 6 gezeigten Betriebszuständen erfolgt demnach eine besonders Energie effiziente direkte freie Kühlung des Rechenzentrum.

## Patentansprüche

1. Mischbox zur Temperaturregulierung mit einem Grundkörper (1), durch den mindestens ein Luftstrom leitbar ist und in dem mindestens eine Filtereinrichtung (2, 3) angeordnet ist, durch welche der Luftstrom leitbar ist, wobei die Führung des Luftstroms durch eine Klappenanordnung mit mindestens einer Klappe erfolgt, und die Klappenanordnung mindestens drei Klappen (4, 5, 6) umfasst, die in Abhängigkeit eines Parameters, insbesondere in Abhängigkeit eines Umgebungsparameters, steuerbar sind, **dadurch gekennzeichnet, dass** die Klappenanordnung eine Außenluftklappe (4) und eine Umluftklappe (5) und eine Mischluftklappe (6) umfasst.

2. Mischbox zur Temperaturregelung nach Anspruch 1 **dadurch gekennzeichnet, dass** zwei Filtereinrichtungen (2, 3) vorgesehen sind, durch welche der Luftstrom leitbar ist.

3. Mischbox zur Temperaturregelung nach Anspruch 2, **dadurch gekennzeichnet, dass** die Klappenanordnung derart gestaltet und/oder in Abhängigkeit des Parameters derart steuerbar ist dass der Luftstrom eine oder beide Filtereinrichtungen (2, 3) durchtritt.

4. Mischbox zur Temperaturregulierung nach einem der Ansprüche 1 bis 3, **dadurch gekennzeichnet, dass** dem Grundköper (1) ein Kompressor (10) zugeordnet ist.

5. Anlage zur Temperaturregulierung, **dadurch gekennzeichnet, dass** mehrere Mischboxen (20) nach einem der vorhergehenden Ansprüche vorgesehen sind, welche parallel zueinander angeordnet sind.

6. Anlage zur Temperaturregulierung nach Anspruch 5, **dadurch gekennzeichnet, dass** Ventilatoreinrichtungen (11) vorgesehen sind.

7. Verfahren zum Betrieb einer Anlage zur Temperierung nach einem der Ansprüche 5 oder 6, **dadurch gekennzeichnet, dass** die Klappenanordnung derart gesteuert wird, dass in Abhängigkeit eines Parameters, insbesondere in Abhängigkeit der Temperatur, der Luftstrom eine oder beide Filtereinrichtungen (2, 3) durchtritt.

## Claims

1. Mixing box for temperature regulation with a base body (1), through which at least one air stream is conductible and in which at least one filter device (2, 3) is arranged, through which the air stream is conductible, wherein the guidance of the air stream is effected by a valve arrangement having at least one flap, and the valve arrangement comprises at least three flaps (4, 5, 6), which are controllable as a function of a parameter, in particular as a function of an environmental parameter, **characterised in that** the valve arrangement comprises an outside air flap (4) and a recirculated air flap (5) and a mixing air flap (6).

2. Mixing box for temperature regulation in accordance with claim 1, **characterised in that** two filter devices (2, 3) are provided, through which the air stream is conductible.

3. Mixing box for temperature regulation in accordance with claim 2, **characterised in that** the flap valve arrangement is designed and/or is controllable as a function of the parameters in such a way that the air stream flows through one or both filter devices (2, 3).

4. Mixing box for temperature regulation in accordance with any one of claims 1 to 3, **characterised in that** a compressor (10) is associated with the base body (1).

5. System for temperature regulation, **characterised in that** a plurality of mixing boxes (20) are provided in accordance with any one of the preceding claims, arranged parallel to each other.

6. System for temperature regulation in accordance with claim 5, **characterised in that** ventilator devices (11) are provided.

7. Process for operating a temperature regulation system in accordance with any one of claim 5 or 6, **characterised in that** the valve arrangement is controlled in such a way that, as a function of one parameter, in particular depending on temperature, the air stream flows through one or both filter devices (2, 3).

## Revendications

1. Boîte de mélange de régulation de température, comprenant un corps de base (1) dans lequel on peut faire passer au moins un flux d'air et dans lequel est placé au moins un dispositif de filtration (2, 3) dans lequel on peut faire passer le flux d'air, le guidage du flux d'air étant réalisé par un système de clapet comportant au moins un clapet, et le système de clapet comportant au moins trois clapets (4, 5, 6) qui peuvent être commandés en fonction d'un paramètre, notamment en fonction d'un paramètre du milieu ambiant, **caractérisée en ce que** le système de clapets comprend un clapet d'air extérieur (4) et un clapet d'air de circulation (5) et un clapet d'air mélangé (6).

2. Boîte de mélange de régulation de température selon la revendication 1, **caractérisée en ce qu'**il est prévu deux dispositifs de filtration (2, 3) dans lesquels on peut faire passer le flux d'air.

3. Boîte de mélange de régulation de température selon la revendication 2, **caractérisée en ce que** le système de clapets est agencé et/ou peut être commandé en fonction du paramètre, de manière à ce que le flux d'air traverse un des dispositifs de filtration (2, 3) ou les deux.

4. Boîte de mélange de régulation de température selon l'une des revendications 1 à 3, **caractérisée en ce qu'**un compresseur (10) est associé au corps de base (1).

5. Installation de régulation de température, **caractérisée en ce qu'**il est prévu plusieurs boîtes de mélange (20) selon l'une des revendications précédentes, qui sont disposées parallèlement les unes aux autres.

6. Installation de régulation de température selon la revendication 5, **caractérisée en ce qu'**il est prévu des dispositifs à ventilateur (11).

7. Procédé d'utilisation d'une installation de régulation de température selon l'une des revendications 5 ou 6, **caractérisé en ce que** le système de clapets est commandé de manière à ce que, en fonction d'un paramètre, notamment en fonction de la température, le flux d'air traverse un des dispositifs de filtration (2, 3) ou les deux.
